Europäisches Patentamt

European Patent Office

Office européen des brevets

(11) Numéro de publication: **0 273 825 B1**

(12) **FASCICULE DE BREVET EUROPEEN**

(45) Date de publication de fascicule du brevet: **08.04.92**

(51) Int. Cl.5: **G01R 31/28**, G01R 1/24, H01P 1/00

(21) Numéro de dépôt: **87402913.5**

(22) Date de dépôt: **18.12.87**

(54) **Dispositif de mesure des caractéristiques d'un composant hyperfréquence.**

(30) Priorité: **23.12.86 FR 8618087**

(43) Date de publication de la demande:
**06.07.88 Bulletin 88/27**

(45) Mention de la délivrance du brevet:
**08.04.92 Bulletin 92/15**

(84) Etats contractants désignés:
**DE ES GB IT NL**

(56) Documents cités:
**US-A- 3 775 644**
**US-A- 4 535 307**
**US-A- 4 538 124**

(73) Titulaire: **THOMSON COMPOSANTS MI-CROONDES**
**173, bld Haussmann**
**F-75008 Paris(FR)**

(72) Inventeur: **Bitoune, Sylviane**
**THOMSON-CSF SCPI 19, avenue de Messine**
**F-75008 Paris(FR)**
Inventeur: **Geffroy, Dominique**
**THOMSON-CSF SCPI 19, avenue de Messine**
**F-75008 Paris(FR)**
Inventeur: **Grossier, François**
**THOMSON-CSF SCPI 19, avenue de Messine**
**F-75008 Paris(FR)**
Inventeur: **Le Creff, Maurice**
**THOMSON-CSF SCPI 19, avenue de Messine**
**F-75008 Paris(FR)**
Inventeur: **Ralala, Gérard**
**THOMSON-CSF SCPI 19, avenue de Messine**
**F-75008 Paris(FR)**

(74) Mandataire: **Taboureau, James et al**
**THOMSON-CSF SCPI**
**F-92045 Paris La Défense Cédex 67(FR)**

## Description

La présente invention concerne un dispositif pour la mesure des caractéristiques des composants hyperfréquences, présentés en puces, ou en boitiers discrets, de circuits intégrés et de circuits hybrides. Il permet de mesurer les paramètres S, de bruit, ou de puissance de sortie, dans la gamme de 2 à 40 GHz.

Tout composant hyperfréquence, qu'il soit sous forme de puce, de matériau semi-conducteur, ou de composant discret (transistor par exemple), ou de circuit intégré (amplificateur par exemple) encapsulé dans un boitier, ou de circuit hybride assemblé sur un substrat, doit être caractérisé selon certains paramètres avant d'être utilisé. Il est courant de mesurer les paramètres de réflexion, et de transmission dits paramètres "S" (scattering parameters), le bruit et la puissance de sortie. Ces mesures se font en appliquant un signal hyperfréquence sur une borne d'entrée, une impédance adaptée sur une borne de sortie, et on mesure le coefficient de réflexion et le gain dans les différents cas de figures possibles, si le composant a plus de deux bornes d'accès extérieurs. Bien connues de l'homme de l'art, ces mesures se pratiquent au moyen d'un matériel qui comporte un poste de test, avec la place pour incorporer un circuit à mesurer, et deux connexions d'entrée et de sortie, fixes par rapport à l'appareil de mesure.

Il faut donc deux lignes microbandes adaptées à 50 ohms, pour les lignes d'entrée et de sortie, et des lignes pour la polarisation du composant en cours de mesure.

Pour un matériel de mesure donné, il faut autant de boitiers pour supporter le composant à mesurer qu'il y a de types de composants : puces, boitier discret, boitier de circuit intégré, circuit hybride.

En outre, les deux lignes microbandes d'entrée et de sortie étant en position fixe sur le matériel de mesure, il est nécessaire d'établir pour chaque mesure une liaison électrique entre la microbande d'entrée (ou de sortie) et celle des bornes du composant qui correspond à la mesure effectuée, cette borne n'étant pas nécessairement dans l'alignement de la microbande à laquelle elle est reliée. Il en résulte une longueur de fil ou de ruban métalliques qui désadapte la microbande considérée, et cette désadaptation peut au pire se répéter en entrée et en sortie du composant mesuré.

Les appareils actuels ont donc deux connexions d'accès, constituées par un connecteur coaxial et une microbande, qui sont fixes, et un espace qui les sépare, de dimensions fixes également, et il faut souder des fils ou rubans pour contrecarrer cette fixité de l'appareil, et choisir les bornes sur lesquelles se fait la mesure, ce qui entraine une désadaptation des connexions d'accès.

Cependant, il est connu du document US-A-4 535 307 un appareil de test de circuit hyperfréquence dans lequel le circuit est supporté par un bloc métallique, et les deux connexions d'accès sont supportées par deux autres blocs. Cela permet de donner aux blocs d'accès un degré de liberté en position par rapport au circuit à mesurer.

Il est également connu du document US-A-3 775 644 un support ajustable pour un substrat hyperfréquence. Selon ce document, ce sont les connexions d'accès qui coulissent et se déplacent le long des bords du substrat.

Aucun de ces deux documents ne résout le problème général du test de circuits de dimensions comprises entre celles d'une puce et celles d'un circuit hybride hyperfréquence.

Le dispositif de mesure selon l'invention apporte une solution à ces inconvénients, en proposant que les deux connexions d'accès (connecteur coaxial + microbande) soient mobiles selon deux axes situés dans un même plan.

Selon l'invention, chaque connexion d'accès est solidaire d'un bloc solide, dont au moins la surface est en bonne conductrice de l'électricité. Chaque bloc supporte une ligne microbande, sur une face supérieure horizontale, et un connecteur coaxial. Les deux blocs, mobiles, peuvent être plus ou moins écartés selon un premier axe parallèle aux lignes microbandes, de façon à s'adapter aux dimensions géométriques du composent à mesurer. Leur écartement est fixé par une vis.

De plus, les deux blocs peuvent se déplacer, à écartement déterminé, par translation latérale l'un par rapport à l'autre, selon un second axe perpendiculaire aux lignes microbandes, mais dans le plan de ces dites microbandes. Ce second degré de liberté permet d'aligner :

- d'abord la borne d'entrée du composent à mesurer sur la ligne microbande d'entrée,
- ensuite la ligne microbande de sortie sur la borne de sortie du composant à mesurer.

Les liaisons électriques à établir sont donc de longueur nulle ou minimale.

Un troisième bloc s'insère entre les deux blocs d'accès. Métallique ou métalllsé en surface, il sert de support mécanique au composant à mesurer, et comporte des moyens assurant le mouvement relatif de translation latérale des deux blocs d'accès l'un par rapport à l'autre, selon le second degré de liberté. Un jeu de troisièmes blocs permet d'adapter l'appareil aux dimensions des différents types de composants : puces, boitiers, substrats de circuits hybrides.

De façon plus précise, l'invention concerne un dispositif pour la mesure des caractéristiques d'un composant hyperfréquence, comportant deux lignes d'accès au composant à mesurer, chaque ligne d'accès étant constituée par un connecteur coaxial et une ligne microbande, supportés par un bloc d'accès, le composant étant lui aussi supporté par un bloc inséré entre les deux blocs d'accès ce dispositif étant caractérisé en ce que les deux blocs d'accès sont réglables en position, par rapport au composant à mesurer, selon deux degrés de liberté :

- le premier degré de liberté, en écartement, étant d'axe parallèle aux lignes microbandes
- le second degré de liberté, en translation latérale, étant d'axe perpendiculaire aux lignes microbandes mais dans le plan défini par lesdites lignes microbandes.

L'invention sera mieux comprise par la description qui suit d'un exemple de réalisation, et ses avantages ressortiront grâce aux figures jointes en annexes et qui représentent :

- figure 1 : vue dans l'espace, éclatée, d'un dispositif selon l'invention, dans une configuration permettant de mesurer ses caractéristiques propres (sans composant)
- figure 2 : vue dans l'espace, éclatée, du même dispositif muni d'un premier type de bloc support de composant,
- figure 3 : vue comparable à la figure 2, le dispositif étant muni d'un second type de bloc support de composant,
- figure 4 : vue du bloc support de composant, pour la mesure des caractéristiques sur une puce de semiconducteur.

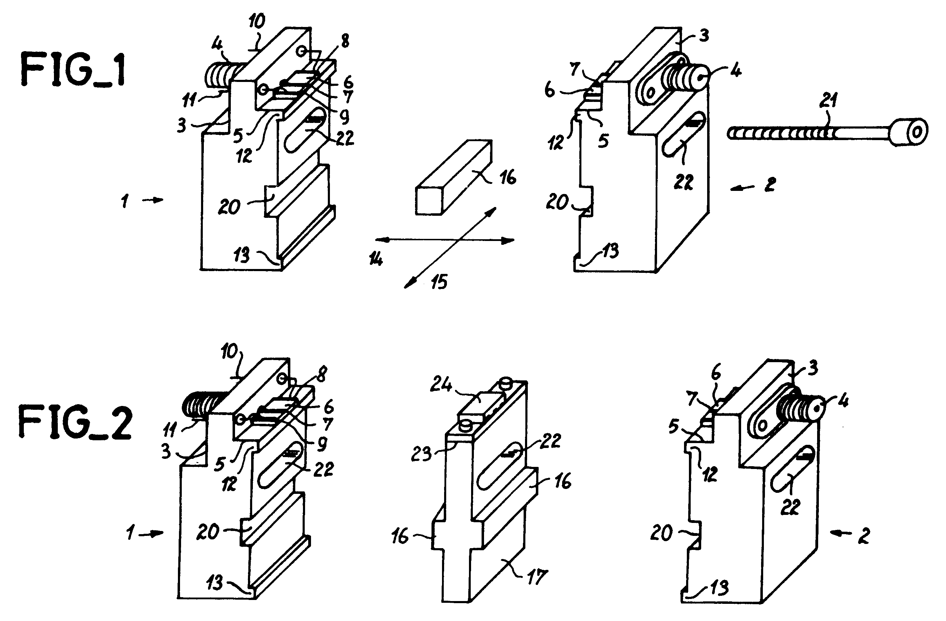

La figure 1 représente une vue, éclatée dans l'espace pour en mieux montrer les détails, des deux blocs d'accès du dispositif de l'invention. Le bloc 1 constitue par exemple le bloc d'accès de la voie d'entrée, et le bloc 2 est alors celui de la voie de sortie. La forme globale de chacun de ces blocs n'est pas primordiale pour le fonctionnement : il faut néanmoins qu'ils comportent un certain nombre de facettes planes, dont les fonctions seront précisées ultérieurement. La matière de ces blocs d'accès n'est pas critique, du moment que la surface des blocs est bonne conductrice de l'électricité pour une bonne mise à la masse. Ils sont donc réalisés soit en métal, soit en céramique ou en matériaux plastiques, et métallisés en surface.

Les blocs d'accès 1 et 2 sont, à des détails près, symétriques optiques par rapport au plan de leur face de contact, lorsqu'ils sont serrés l'un contre l'autre.

Chaque bloc d'accès comporte, dans une partie supérieure, une facette verticale 3, sur laquelle est fixé un connecteur coaxial 4 - ou une prise de contact équivalente en hyperfréquence-, et une facette horizontale 5 sur laquelle est fixée une plaquette 6 de matériau céramique, tel qu'alumine ou oxyde de béryllium.

Chaque plaquette céramique 6 porte, sur sa face principale apparente, une microbande 7 dans l'alignement du conducteur central du connecteur coaxial 4 : les dimensions et l'épaisseur de la plaquette 6 sont donc calculées pour que les lignes microbandes 7 soient adaptées en impédance à 50 ohms - valeur normalisée - entre 2 et 40 GHz. Les microbandes 7 sont soudées, chacune, sur le conducteur central du connecteur 4 qui leur correspond. Au moins l'une des deux plaquettes céramiques 6 supporte en plus deux métallisations 8 et 9, de forme quelconque, reliées chacune par un fil métallique à une connexion 10 et 11, fixée dans le bloc d'accès par une perle de verre. Les deux connexions 10 et 11 et les deux métallisations 8 et 9 permettent d'amener une polarisation sur le composant à mesurer.

Chaque bloc d'accès 1 et 2 comporte en outre deux lèvres 12 et 13, disposées en saillie sur les faces en regard des deux blocs : lorsque ceux-ci sont serrés, les lèvres 12 et 13 assurent une bonne continuité électrique du plan de masse.

D'un point de vue mécanique, les deux blocs disposent d'un premier degré de liberté, en écartement, selon l'axe commun aux microbandes 7 et aux conducteurs centraux des connecteurs 4 : cet axe est symbolisé sur la figure 1 par une flèche 14. Les blocs peuvent être écartés l'un de l'autre soit d'une distance nulle - cas de la figure 1 : mesure des caractéristiques propres au dispositif seul - soit d'une distance imposée par les dimensions du composant à mesurer. Dans ce cas, un bloc support de composant est inséré entre les deux blocs d'accès 1 et 2 : de tels blocs d'insert 17, 18 et 19 sont représentés en figures 2, 3 et 4. Ils seront détaillés ultérieurement.

Les blocs d'accès 1 et 2 disposent en outre d'un second degré de liberté, en translation latérale, selon un axe perpendiculaire aux lignes microbandes 7, dans le plan des plaquettes 6. Cet axe est symbolisé par la flèche 15. Le déplacement latéral du bloc 1 par rapport au bloc 2 est contrôlé par un système constitué par une gorge 20, dans chacun des deux blocs 1 et 2, qui coopère avec un rail 16. Bien entendu, les gorges 20 sont usinées, dans les faces en regard des blocs 1 et 2, parallèles à l'axe du second degré de liberté.

Les blocs d'insert 17, 18 et 19 comportent chacun, selon leurs dimensions, soit un rail 16, soit deux moitiés de rail 16, sur leurs faces en regard avec les blocs d'accès 1 et 2.

L'assemblage d'un bloc d'accès 1, d'un bloc d'insert 17 ou 18 ou 19 et d'un bloc d'accès 2 permet, grâce à la translation le long du rail 16, de faire coïncider la microbande d'entrée 7 avec celle des bornes d'entrée choisie sur le composant à mesurer, et la microbande de sortie 7 avec celle des bornes de sortie choisie sur le composant à mesurer. Lorsque cette double coïncidence est obtenue, l'assemblage est immobilisé par serrage au moyen d'une vis 21, qui traverse les trois blocs à travers des boutonnières 22, pour permettre le déplacement latéral.

Avant de poursuivre la description du dispositif selon l'invention, il sera intéressant d'en indiquer les mesures de calibration, en pertes et en taux d'ondes stationnaires, effectuées sur le dispositif seul, sans composant, tel qu'il est représenté en figure 1 - mais dans un état serré par la vis 21 bien entendu -. Les deux microbandes 7 sont connectées l'une à l'autre par thermosoudure, et les lèvres 12 et 13 sont en contact direct. On effectue 3 mesures scalaires sur l'appareil, sans composant.

En appliquant un signal hyperfréquence sur un connecteur coaxial 4 d'entrée, on peut mesurer les pertes du dispositif, y compris les connecteurs, en recueillant ce signal sur le connecteur coaxial 4 de sortie. Les mesures sont faites en amplitude : elles permettent de connaitre les pertes intrinsèques du dispositif, et de les mettre en mémoire.

La calibration en taux d'ondes stationnaires se fait en deux temps, en supposant que les deux blocs d'accès sont identiques. Une première mesure se fait en circuit ouvert sur un bloc d'accès séparé - il n'est donc plus vissé sur l'autre bloc d'accès - et la ligne microbande 7 n'étant pas connectée sur une charge. Dans une deuxième mesure en court-circuit, la ligne microbande 50 ohms est mise à la masse en bout de ligne : on soude un fil entre le bout de la ligne 7 et le bloc d'accès 1 ou 2.

Cette calibration étant faite, un bloc d'insert, tel que le bloc 17 en figure 2, peut être inséré entre les deux blocs d'accès 1 et 2. Ce bloc d'insert 17, destiné à supporter le composant, est essentiellement caractérisé en ce que :

- au moins sa surface est conductrice de l'électricité, de façon à assurer la continuité du plan de masse avec les blocs d'accès 1 et 2,
- il a une facette supérieure 23 qui a les mêmes dimensions que le composant 24 qui y est fixé,
- il comporte, sur chaque face en regard avec les blocs d'accès un rail 16 qui coopère avec les gorges 20 dans les blocs d'accès,
- il comporte un orifice 22 en forme de boutonnière, pour le passage de la vis 21.

Des mesures vectorielles permettent de déterminer les paramètres en "S" des blocs d'accès 1 et 2. Pour cela, une ligne 50 ohms est fixée sur le bloc d'insert 17, ce qui permet de faire varier les phases d'un signal hyperfréquence appliqué sur un connecteur coaxial 4.

Puis un composant à tester 24 est fixé sur la facette 23 du bloc d'insert 17, à la place de la ligne 50 ohms. Les coïncidences entre microbandes 7 et bornes d'entrée et de sortie du composant 24 étant obtenues, la vis 21 est serrée, et les raccordements électriques effectués par thermocompression de fils ou rubans, très courts, sur les microbandes 7 et sur les métallisations de polarisation 8 et 9. Les paramètres en "S" du composant sont extraits par le calcul de la mesure globale, selon la méthode dite d'épluchage ou de "de-embedding", connue et qu'il n'y a pas lieu de décrire ici.

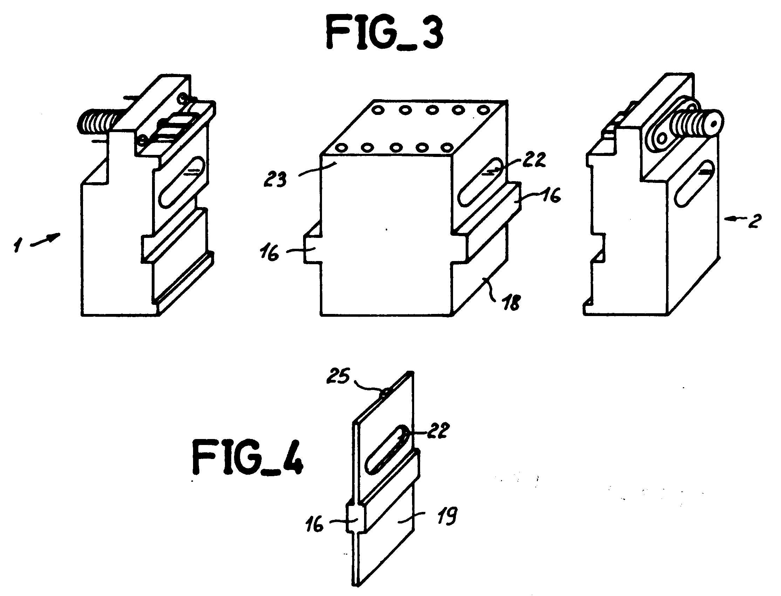

Le bloc d'insert 17 de la figure 2 correspond à un composant 24 monté dans un petit boitier rectangulaire. Dans certains cas, on peut être amené à utiliser une pluralité de composants en série, par exemple des amplificateurs montés en série pour obtenir plus de gain : on utilisera alors un bloc d'insert 18 tel que représenté en figure 3. Ou au contraire on peut mesurer une puce de composant semiconducteur 25, au moyen de l'insert 19 de la figure 4. D'autres modèles d'inserts peuvent être réalisés selon les dimensions du composant à mesurer mais, dans tous les cas, la facette supérieure 23 du bloc d'insert est dans le plan des facettes 5 des blocs d'accès 1 et 2, et a des dimensions telles que les bornes d'entrée et de sortie du composant sont au ras de l'extrémité libre des lignes microbandes 7, de sorte que le fil de jonction à thermocomprimer est de longueur minimale.

On observera que ce résultat est obtenu parce que les deux blocs d'accès 1 et 2 jouissent de deux degrés de liberté, ce qui permet de faire coïncider les lignes microbandes 7 avec les bornes du composant choisies pour la mesure.

## Revendications

1. Dispositif de mesure des caractéristiques d'un composant hyperfréquence, comportant deux lignes d'accès au composant (24) à mesurer, chaque ligne d'accès étant constituée par un connecteur coaxial (4) et une ligne microbande (7) supportés par un bloc d'accès (1,2), le composant (24) étant lui aussi supporté par un bloc (17,18,19) inséré entre les deux blocs d'accès (1,2) ce dispositif étant caractérisé en ce que les deux blocs d'accès sont réglables en position, par rapport au composant (24) à mesurer, selon deux degrés de liberté :
   - le premier degré de liberté, en écartement, étant d'axe (14) parallèle aux lignes microbandes (7)
   - le second degré de liberté, en translation latérale, étant d'axe (15) perpendiculaire aux lignes microbandes (7) mais dans le plan défini par lesdites lignes microbandes (7).

2. Dispositif selon la revendication 1, caractérisé en ce que chacun des deux blocs d'accès (1, 2) est métallique ou en matériau métallisé en surface pour assurer la continuité du plan de masse électrique, et en ce qu'il comporte au moins une facette verticale (3) sur laquelle est fixé un connecteur coaxial (4) d'entrée ou de sortie, et au moins une facette horizontale (5) sur laquelle est fixée une ligne microbande (7), supportée par une plaquette céramique (6), la ligne microbande (7) étant brasée sur le conducteur central du connecteur coaxial (4).

3. Dispositif selon la revendication 1, caractérisé en ce que chacun des deux blocs d'accès (1, 2) comporte, sur sa face en regard avec l'autre bloc d'accès, deux lèvres (12, 13) pour assurer la continuité du plan de masse électrique lorsque les blocs (1, 2) sont en contact par le bloc (17, 18, 19).

4. Dispositif selon la revendication 1, caractérisé en ce que chaque bloc d'accès (1, 2) comporte, sur sa face en regard avec l'autre bloc d'accès, une gorge (20) qui coopère avec un rail (16) pour contrôler le déplacement des blocs (1, 2) l'un par rapport à l'autre selon l'axe (15) du second degré de liberté.

5. Dispositif selon la revendication 1, caractérisé en ce que le bloc d'insert (17) comporte une facette supérieure horizontale (23) qui est dans le même plan que les facettes horizontales (5) des deux blocs d'accès (1, 2), et qui a des dimensions égales à celles du composant (24) à mesurer.

6. Dispositif selon la revendication 1, caractérisé en ce que le bloc d'insert (17) comporte sur ses deux faces en regard avec les blocs d'accès (1, 2) deux rails (16) qui coopèrent avec les gorges (20) creusées dans les blocs d'accès (1, 2).

7. Dispositif selon la revendication 1, caractérisé en ce que chacun des deux blocs d'accès (1, 2) et le bloc d'insert (17) comportent un orifice (22) en forme de boutonnière, permettant à une vis de serrage (21) de passer à travers lesdits blocs pour les immobiliser.

8. Dispositif selon la revendication 1, caractérisé en ce que l'un au moins des deux blocs d'accès (1, 2) comporte des moyens de polarisation du composant (24) à mesurer, lesdits moyens étant constitués par deux métallisations (8, 9) supportées par la plaquette (6) de céramique d'une ligne microbande (7), et par deux connexions externes (10, 11) qui sont fixées dans le bloc d'accès (1, 2) au moyen de perles de verre, et réunies aux métallisations (8, 9) par des fils.

## Claims

1. A device for the measurement of the characteristics of a microwave component comprising two access lines to the component (24) to be measured, each access line being constituted by a coaxial connector (4) and a microband line (7) supported by an access block (1 and 2), the said component (24) also being supported by a block (17, 18 and 19) positioned between the two access blocks (1 and 2), the said device being characterized in that the two access blocks are able to be changed in position in relation to the component (24) to be measured with two degrees of freedom:
   - the first degree of freedom, by way of removal, being an axis (14) parallel to the microband lines (7), and
   - the second degree of freedom, by way of lateral translation, being an axis (15) perpendicular to the microband lines (7) in a plane defined by the said microband lines (7).

2. The device as claimed in claim 1, characterized in that each of the two access blocks (1 and 2) are metallic or made of a material with a metallized surface in order to ensure the continuity of the plane of electrical grounding and in that it comprises at least one vertical surface (3) on which an input or output coaxial connector (4) is secured and at least one horizontal face (5) on which there is secured a microband line (7) supported by a ceramic plate (6), the microband line (7) being brazed on the central conductor of the coaxial connector (4).

3. The device as claimed in claim 1, characterized in that each of the two access blocks (1 and 2) comprises, on a surface facing the other access block, two lips (12 and 13) in order to ensure the continuity of the plane of electrical grounding when the blocks (1 and 2) are in contact via the block (17, 18 and 19).

4. The device as claimed in claim 1, characterized in that each access block (1 and 2) comprises, on the surface facing the other access block, a slot (20) which cooperates with a rail (16) in order to guide the displacement of the blocks (1 and 2), the one in relation to the other, along the axis (15) of the second degree of freedom.

**5.** The device as claimed in claim 1, characterized in that the inserted block (17) comprises an upper horizontal surface (23) which is in the same plane as the horizontal surfaces (5) of the two access blocks (1 and 2) and which has dimensions equal to those of the component (24) to be measured.

**6.** The device as claimed in claim 1, characterized in that the insertion block (17) comprises on its two faces opposite to the access blocks (1 and 2) two rails which cooperate with the slots (20) made in the access blocks (1 and 2).

**7.** The device as claimed in claim 1, characterized in that each of the two access blocks (1 and 2) and the insertion block (17) comprise an orifice (22) in the form of a slot making it possible for a gripping screw (21) to pass through the said blocks in order to hold them in place.

**8.** The device as claimed in claim 1, characterized in that at least one of the two access blacks (1 and 2) comprises polarizing means for the component to be measured, the said means being constituted by metallized layers (8 and 9) carried by the ceramic plate (6) of a microband line (7) and by two external connections (10 and 11) which are secured in the access block (12) by the intermediary of glass beads and connected with the metallized layers (8 and 9) by wires.

**Patentansprüche**

**1.** Einrichtung zum Messen der Eigenschaften eines Ultrahochfrequenz-Bauelementes, mit zwei Zugriffsleitungen für das zu messende Bauelement (24), wobei jede Zugriffsleitung von einem Koaxverbinder (4) und einer Mikrostreifen-Leitung (7), die von einem Zugriffsblock (1, 2) gehalten werden, gebildet wird, wobei das Bauelement (24) selbst von einem zwischen die zwei Zugriffsblöcke (1, 2) eingesetzten Block (17, 18, 19) gehalten wird, wobei diese Einrichtung dadurch gekennzeichnet ist, daß die Positionen der zwei Zugriffsblöcke in bezug auf das zu messende Bauelement (24) in den zwei folgenden Freiheitsgraden einstellbar ist:

    - dem ersten Freiheitsgrad des Abstandes, der durch die zu den Mikrostreifen-Leitungen (7) parallele Achse (14) gegeben ist,

    - dem zweiten Freiheitsgrad der seitlichen Translation, der durch die zu den Mikrostreifen-Leitungen (7) senkrechte, jedoch in der durch die Mikrostreifen-Leitungen (7) definierten Ebene liegende Achse (15) gegeben ist.

**2.** Einrichtung gemäß Anspruch 1, dadurch gekennzeichnet, daß die Oberfläche eines jeden der zwei Zugriffsblöcke (1, 2) metallisch oder aus einem metallisierten Material ist, um die Kontinuität der elektrischen Masseebene zu gewährleisten, und daß sie wenigstens eine vertikale Freifläche (3), auf der ein Eingangs- oder Ausgangs-Koaxverbinder (4) befestigt ist, und wenigstens eine horizontale Freifläche (5), auf der eine von einer keramischen Platte (6) getragene Mikrostreifen- Leitung (7) befestigt ist, aufweist, wobei die Mikrostreifen- Leitung (7) mit dem Mittelleiter des Koaxverbinders (4) verlötet ist.

**3.** Einrichtung gemäß Anspruch 1, dadurch gekennzeichnet, daß jeder der zwei Zugriffsblöcke (1, 2) auf seiner dem anderen Zugriffsblock zugewandten Seite zwei Leisten (12, 13) aufweist, um die Kontinuität der elektrischen Masseebene zu gewährleisten, wenn sich die Blöcke (1, 2) über den Block (17, 18, 19) in Kontakt befinden.

**4.** Einrichtung gemäß Anspruch 1, dadurch gekennzeichnet, daß jeder Zugriffsblock (1, 2) auf seiner dem anderen Zugriffsblock zugewandten Seite eine Vertiefung (20) aufweist, die mit einer Schiene (16) zusammenwirkt, um die gegenseitige Verschiebung der Blöcke (1, 2) entlang der Achse (15) des zweiten Freiheitsgrades zu steuern.

**5.** Einrichtung gemäß Anspruch 1, dadurch gekennzeichnet, daß der eingesetzte Block (17) eine obere horizontale Schlifffläche (23) aufweist, die in derselben Ebene wie die horizontalen Freiflächen (5) der zwei Zugriffsblöcke (1, 2) liegt und die gleichen Abmessungen wie diejenigen des zu messenden Bauelementes (24) besitzt.

**6.** Einrichtung gemäß Anspruch 1, dadurch gekennzeichnet, daß der eingesetzte Block (17) an seinen den Zugriffsblöcken (1, 2) zugewandten Seiten zwei Schienen (16) aufweist, die mit den in den Zugriffsblöcken (1, 2) ausgesparten Vertiefungen (20) zusammenwirken.

**7.** Einrichtung gemäß Anspruch 1, dadurch gekennzeichnet, daß jeder der zwei Zugriffsblöcke (1, 2) und der eingesetzte Block (17) eine Öffnung (22) in Form einer länglichen Aussparung aufweisen, die einer Klemmschraube (21) den Durchgang durch die Blöcke ermöglichen, um diese unbeweglich zu machen.

8. Einrichtung gemäß Anspruch 1, dadurch gekennzeichnet, daß wenigstens einer der zwei Zugriffsblöcke (1, 2) Mittel für die Polarisation des zu messenden Bauelementes (24) aufweist, wobei die Mittel von zwei von der Keramikplatte (6) einer Mikrostreifen-Leitung (7) gehaltenen Metallisierungen (8, 9) und von zwei externen Verbindungen (10, 11), die im Zugriffsblock (1, 2) mittels Glasperlen befestigt sind und mit den Metallisierungen (8, 9) durch Drähte verbunden sind, gebildet werden.

FIG_1

FIG_2

# FIG_3

23
22
16
16
18
1
2

# FIG_4

25
22
16
19

EP 0 273 825 B1